# EUROPÄISCHE PATENTSCHRIFT

(11) **EP 0 997 997 B1**
(45) Veröffentlichungstag und Bekanntmachung des Hinweises auf die Patenterteilung: **11.12.2002**
(21) Anmeldenummer: 99119402.8
(22) Anmeldetag: 30.09.1999
(51) Int. Cl.: H01S 5/40, H01S 5/14

(54) **Verfahren und Vorrichtung für die kohärente Addition der Emission von Halbleiterlasern**
Method and apparatus for coherently combining the emission of semiconductor laser devices
Méthode et dispositif d'addition cohérente de l'émission de lasers à semi-conducteur

(30) Priorität: 29.10.1998 DE 19849869
(43) Veröffentlichungstag der Anmeldung: 03.05.2000
(73) Patentinhaber: Deutsche Telekom AG, 53113 Bonn (DE)
(72) Erfinder: Dultz, Wolfgang, Prof.Dr., 65936 Frankfurt/M. (DE); Angelow, Gregor, 64285 Darmstadt (DE); Laeri, Franco, 64295 Darmstadt (DE)

(56) Entgegenhaltungen:
- US-A- 4 246 548
- US-A- 4 933 649
- US-A- 4 972 427
- US-A- 5 033 060
- US-A- 5 446 754

## Beschreibung

Die Erfindung betrifft ein Verfahren für die kohärente Addition der Emission von Halbleiterlasern nach dem Oberbegriff des Patentanspruchs 1 und eine Vorrichtung nach dem Oberbegriff des Patentanspruchs 5.

Die von einem Halbleiter abgestrahlte Lichtleistung wird grundsätzlich begrenzt durch die Leistungsdichte auf den Halbleiterauskoppelflächen. Wird die Schwelle für Materialzerstörung (Zerstörschwelle) überschritten, kommt es in der Kristallendfläche zu irreversiblen Schäden und die Laseremission bricht zusammen. Eine Steigerung der Laserleistung bei Halbleiterlasern kann nach dem bisherigen Stand der Technik nur durch eine Vergrößerung der Querschnittsfläche erreicht werden. Da die Dicke der lichtemittierenden Schicht bei Streifendiodenlasern aber technologisch festgelegt ist, erfolgt die Vergrößerung des Querschnitts in der Regel über die Vergrößerung der Streifenbreite (Breitstreifendioden).

Die Vergrößerung der Emissionsfläche hat aber eine wichtige, unerwünschte Konsequenz, nämlich die Strahlqualität nimmt ab. Als Bestimmungsgröße für die Strahlqualität kann die Fokussierbarkeit der Strahlleistung, das heißt die im Fokusfleck maximal erreichbare Leistungsdichte betrachtet werden. Die höchsten Leistungsdichten lassen sich bei einmodiger Strahlung erreichen (Beugungslimit). Durch die Verbreiterung des Emissionsstreifens der Laserdioden wird aber das emittierte Licht mehrmodig. Obschon die emittierte Leistung der Diode zunimmt, läßt sich diese Leistung dann nicht in einem kleinen Fokusfleck fokussieren. Die Fleckgröße nimmt nämlich zu und zwar quasi proportional zur Wurzel aus der Modenanzahl. Die Leistungsdichte bleibt bestenfalls konstant. In diesem Sinne bringt die Skalierung der Laserquerschnittsfläche zwar mehr Ausgangsleistung, diese verteilt sich jedoch auf mehrere Moden. Leider lassen sich diese Moden nicht alle kohärent in den gleichen Fleck fokussieren. Dies ist für viele Anwendungen von beträchtlichem Nachteil, so zum Beispiel, wenn die Laserstrahlung in eine Monomodefaser eingekoppelt werden soll oder wenn im Fokus Materialbearbeitung durchgeführt werden soll. Dazu kommt noch, daß ein mehrmodiges Feld nicht gut kollimiert werden kann, das heißt es divergiert stärker, was nachteilig ist, wenn das Licht durch freie Propagation über größere Strecken transportiert werden soll (Kommunikation oder dergleichen). In dem Artikel von G. Angelow, F. Laeri und Theo Tschudi "Designing resonators with large mode volume and time mode discrimination", Optics Letters/Volume 21, No. 17/ September 1, 1996 ist eine Spezifizierung der Möglichkeiten des in der DE 43 31 979 C2 enthaltenen Verfahrens zur Herstellung eines Streukörpers zum Einsatz in einem optischen Resonator und der Vorrichtung zur Erzeugung einer vorgebbaren Lichtverteilung mit dem Streukörper für Laserdioden, deren Technologie und Markt sich vor allem in Anwendung in der Telekommunikationstechnik rasant entwickelt, beschrieben.

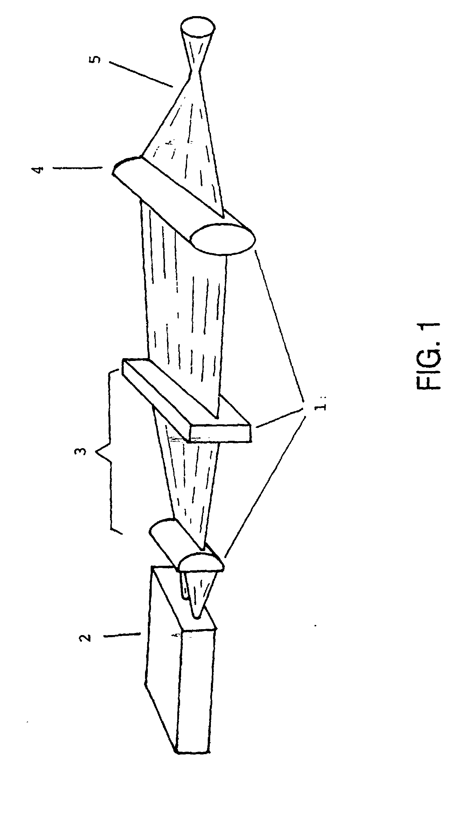

In der US 5,033,060 A, insbesondere in den Figuren 1 und 10 sowie Spalte 2, Zeilen 31 bis 33 und der Zusammenfassung ist eine Laservorrichtung für kohärente Addition der Emission von Halbleiterlasern gezeigt bzw. beschrieben die mit einem Laserarray als ein- oder mehrdimensionales Array ausgestattet ist. Das Fasenkorrektionsarray ist als Multilevel Diffracative Optisches Array realisiert und generiert eine substantielle uniforme Phasenverteilung für das vom Laserarray abgegebene Licht.

Außerdem ist in der US 4,972,427, insbesondere Zeilen 4 bis 6; Zeilen 29 bis 33 und Spalte 3, Zeilen 34 bis 48 eine Laservorrichtung beschrieben, die ein monolithisches lineares Array von Laseremittern aufweist, wobei Einzelemitter in Form von Einzeldioden einer Diodenmatrix oder Diodenbarren angeordnet sind.

Außerdem ist in der US 4,933,649 A, Spalte 1, Zeilen 48 bis 59 und in der US 4,649,351 A ebenfalls eine Laservorrichtung sowie ein Verfahren für die kohärente Addition der Emission von Halbleiterlasern beschrieben. Auch hier sind die Einzelemitter in Form von Einzeldioden in einer Diodenmatrix bzw. in einem Diodenbarren ein- bzw. zweidimensional angeordnet.

Der Erfindung liegt die Aufgabe zugrunde, ein Verfahren und eine Vorrichtung für die kohärente Addition der Emission von Halbleiterlasern zu schaffen, womit ein großes Modenvolumen erreicht wird, damit darin möglichst viele Einzelemitter untergebracht werden können, wobei frei wählbare Modengeometrie realisierbar gemacht werden soll, damit zum Beispiel der Resonator gut an die Emissionsgeometrie eines Breitstreifens oder mehrerer anpassbar ist, womit außerdem eine gute Modenselektion erreicht werden soll, das heißt alle Resonator-Eigenmoden sollen große Verluste haben, außer der gewünschte, der dann ausschließlich zur Emission kommen soll und wobei die Verteilung der optischen Leistung der Gauss-Verteilung entsprechen soll.

Die erfindungsgemäße Lösung für das Verfahren ist im Kennzeichen des Patentanspruchs 1 charakterisiert.

Weitere Lösungen für das Verfahren bzw. Ausgestaltungen der Erfindung sind in den Patentansprüchen 2 und 4 charakterisiert.

Die Lösung für die Vorrichtung zur Durchführung des Verfahrens ist im Kennzeichen des Patentanspruchs 5 charakterisiert. Weitere Ausgestaltungen der erfindungsgemäßen Vorrichtung sind in den Patentansprüchen 6 bis 9 charakterisiert.

Sowohl das erfindungsgemäße Verfahren als auch die erfindungsgemäße Vorrichtung bringen vor allem für die Telekommunikation beträchtliche Vorteile. Sie gestatten nämlich die Erhöhung der Einkoppeleffizienz der Strahlung von Hochleistungslasern in Glasfasern, was zum Beispiel beim Pumpen von Glasfaserverstärkern oder bei der nichtlinearen Übertragung (Solitonen) zum Tragen kommt. Besonders im ersten Beispiel der Einkopplung von Pumpstrahlung in einen Glasfaserverstärker, treten die Vorteile hervor, weil in dieser Anwendung ein O-förmiges Strahlprofil oft optimaler ist. Der Laserresonator kann jetzt so gestaltet werden, daß das O-Profil vom Laserresonator direkt emitiert wird.

Mit den Merkmalen der vorliegenden Erfindung wird es möglich, ein großes Modenvolumen zu realisieren, und somit werden erstmals viele Einzelemitter tatsächlich untergebracht. Außerdem liegt jetzt eine frei wählbare Modengeometrie vor, so daß der Resonator gut an die Emissionsgeometrie eines Breitstreifens oder mehrerer anpassbar ist.

Das erfindungsgemäße Verfahren und die Vorrichtung ermöglichen außerdem eine gute Modenselektion, das heißt alle Resonator-Eigenmoden weisen große Verluste auf, außer der gewünschte, der dann ausschließlich zur Emission kommen soll. Außerdem ist durch die erfindungsgemäße Lösung die Verteilung der optischen Leistung entsprechend der Gauss-Verteilung realisiert. Sie zeichnet sich dadurch aus, daß sie propagationsinvariant ist, das heißt sowohl Fern- wie auch Nahfeld sind gaussförmig.

Dadurch, daß das Konstruktionsproblem als mathematisches Optimierungsproblem interpretiert wurde, das mit den Werkzeugen der globalen Optimierung behandelt wird, wie zum Beispiel der Methode des simulierten Annealings gemäß der Veröffentlichung von S. Kirkpatrick, C.D. Gelatt Jr., und M.P. Vecchi, in Science, Vol. 220, No. 4598, 13. Mai 1983, Seiten 671 bis 680, wird die Form des Resonatorspiegels so lange optimiert, bis sie einen vorgeschriebenen Satz von mathematisch formulierten Forderungen im Sinne eines gesetzten Kriteriums optimal erfüllt, wobei sich außer den aufgestellten Forderungen auch zusätzliche Randbedingungen, wie zum Beispiel besondere Eigenschaften des Spiegelherstellungsverfahrens, einbringen lassen. Mit dieser Methode kann immer ein Eigenmode mit geringen Verlusten präpariert werden, während der Rest des Modenspektrums viele Verluste aufgebürdet bekommt. Einzelmodeemission ist also zu erreichen. Die Spiegel des zugeordneten Resonators sind aber nicht sphärisch und das Modenspektrum liegt nicht mehr in der Klasse der Hermite-Gauss-Moden. Der emittierte Mode weist aber als singuläres Element des Eigenwert-Spektrums eine stationäre Phasenverteilung auf. Dies ist der große Gewinn, denn so ein Strahl läßt sich immer durch ein generalisiertes Linsensystem (vergleiche Schmitt-Korrekturplatte) in jede beliebige Verteilung transformieren, insbesondere auch in eine Gauss-Verteilung.
Weitere Vorteile, Merkmale und Anwendungsmöglichkeiten der vorliegenden Erfindung, insbesondere die Anordnung der Einzelemitter zwischen Spiegeln, ergeben sich aus der nachfolgenden Beschreibung in Verbindung mit dem in der Zeichnung dargestellten Ausführungsbeispiel.

Die Erfindung wird im folgenden anhand von in der Zeichnung dargestellten Ausführungsbeispielen näher beschrieben. In der Beschreibung, in den Patentansprüchen, der Zusammenfassung und in der Zeichnung werden die in der hinten angeführten Liste der Bezugszeichen verwendeten Begriffe und zugeordneten Bezugszeichen verwendet.

In der Zeichnung bedeutet:
- Fig. 1: eine Darstellung von kombinierten refraktiven/diffraktiven optischen Elementen, berechnet als inverses Randwertproblem.

In Fig. 1 sind kombinierte refraktive/diffraktive optische Elemente dargestellt, die als inverses Randwertproblem berechnet wurden. Die Anordnung gemäß Fig. 1 besteht aus drei Spiegeln 1, wo von den beiden linken Spiegeln 1 in der Fig. 1 ein Resonator 3 gebildet wird, der nach einem Diodenbarren 2, hier mit 50 Watt Leistung, angeordnet ist. Dem Resonator 3 schließt sich ein sekundärer Strahlformer 4 an, der eine Leistungsdichte 5 größer 5 Megawatt pro Quadratzentimeter (35W/30µm φ) erzeugt. In diesem Ausführungsbeispiel sind die Einzelemitter als Diodenbarren 2 dargestellt, sie können jedoch auch als Einzeldioden oder Diodenmatrix realisiert werden. Die Anordnung nach Fig. 1 ist nur eine beispielsweise Anordnung, so können zum Beispiel die Einzelemitter auch zwischen zwei oder mehreren Spiegeln 1 angeordnet werden. Wichtig ist, daß mindestens einer dieser Spiegel 1 eine besondere, nichtsphärische Fläche (internes Korrekturelement) aufweist. Alternativ können die Spiegel 1 sphärisch geformt sein, dann aber steht im Resonatorstrahlgang mindestens eine nichtsphärische Phasenplatte als internes Korrekturelement. Außerhalb des Resonators transformiert ein weiteres System von angepaßten Phasenplatten (externe generalisierte Linsen) den emittierten Strahl in die gewünschte Amplituden-/Phasenverteilung.

Die internen Korrekturelemente werden durch ein globales Optimierungsverfahren konstruiert bzw. die internen Korrekturelemente und die externen generalisierten Linsen werden zusammen durch ein globales Optimierungsverfahren konstruiert, wie es zum Beispiel in der genannten Veröffentlichung in Science, Vol. 220 beschrieben ist. Dabei wird die Form der Resonatorspiegel 1 so lange optimiert bis sie einen vorgeschriebenen Satz von mathematisch formulierten Forderungen im Sinne eines gesetzten Kriteriums optimal erfüllt. In den Satz der Forderungen lassen sich die in der Aufgabe genannten Forderungen einbringen und auch zusätzliche Randbedingungen, wie zum Beispiel besondere Eigenschaften des Spiegelherstellungsverfahrens. Es ist klar, daß die Kriterien der Liste im allgemeinen nicht zu 100 Prozent erfüllbar sein wird. Dadurch, daß man den einzelnen Kriterien unterschiedliche Gewichte beimißt, können allerdings auch verschiedene Lösungen erreicht werden. Es ist so, daß mit dieser Methode praktisch immer ein Eigenmode mit geringen Verlusten präpariert werden kann, während der Rest des Modenspektrums viele Verluste aufgebürdet bekommt. Einzelmodeemission ist damit erreichbar. Die Spiegel 1 des zugeordneten Resonators 3 sind aber nicht mehr sphärisch und das Modenspektrum liegt nicht mehr in der Klasse der Hermite-Gauss-Moden. Der emittierte Mode weist aber als singuläres Element des Eigenwert-Spektrums eine stationäre Phasenverteilung auf. Dies ist, wie bereits erwähnt, ein großer Gewinn, denn so ein Strahl läßt sich immer durch ein generalisiertes Linsensystem in jede beliebige Verteilung transformieren also insbesondere auch in eine Gauss-Verteilung. Es läßt sich also zusammenfassend sagen, daß das vorliegende Verfahren bzw. die vorliegende Vorrichtung grundsätzlich auf folgendem beruht:

Die Einzelemitter als Einzeldioden, Diodenmatrix, Diodenbarren oder dergleichen werden zwischen zwei oder mehrere Spiegel 1 gestellt.

Mindestens einer dieser Spiegel 1 weist eine besondere, nichtsphärische Fläche (internes Korrekturelement) auf. Alternativ können die Spiegel 1 sphärisch geformt sein, dann aber steht im Resonatorstrahlengang mindestens eine nichtsphärische Phasenplatte (internes Korrekturelement). Außerhalb des Resonators 3 transformiert ein weiteres System, zum Beispiel in Form eines sekundären Strahlenformers 4, von angepaßten Phasenplatten (externe generalisierte Linsen) den emittierten Strahl in die gewünschte Amplituden-/Phasenverteilung mit der gewünschten Leistungsdichte 5.

Die internen Korrekturelemente werden durch ein globales Optimierungsverfahren konstruiert bzw. die internen Korrekturelemente und die externen generalisierten Linsen werden zusammen durch ein globales Optimierungsverfahren konstruiert.

Beim Einsatz von Streifendioden sind folgende Besonderheiten zu beachten:

Die Streifendioden sind in einer Raumrichtung bereits einmodig. Dies bedeutet, daß die internen und die externen Korrekturelemente nur eindimensionale Struktur aufzuweisen brauchen (parallels Linienmuster, bzw. Zylinderfläche). Dies macht die lithographischen Verfahren besonders attraktiv für die Herstellung der Korrekturelemente. Die internen Korrekturelemente lassen sich so direkt auf die Diodenflächen auftragen oder wegätzen (korrugierte Endflächen).

Bei vertikal emittierenden Dioden (VCSEL) wird die Emission transversal mehrmodig, sobald die emittierende Apertur einige µm überschreitet. Höhere Emissionsleistungen werden von VCSEL-Matrizen erreicht. Die Korrekturelemente werden dann also i.a. eine zweidimensionale Struktur aufweisen. Eine Alternative des Aufbaus besteht noch darin, daß das resonatorinterne Korrekturelement der Laserdiodenkristall ist, dessen Oberflächen mit einem phasenschiebenden Relief versehen sind.

### Liste der Bezugszeichen

- 1: Spiegel
- 2: Diodenbarren
- 3: Resonator
- 4: sekundärer Strahlformer bzw. System
- 5: Leistungsdichte

## Patentansprüche

1. Verfahren für die kohärente Addition der Emission von Halbleiterlasern, wobei Einzelemitter in Form von Einzeldioden einer Diodenmatrix oder Diodenbarren (2) zwischen zwei oder mehrere Spiegel (1) gestellt werden, **dadurch gekennzeichnet,**
**daß** mindestens einer dieser Spiegel (1) eine nichtsphärische Fläche aufweist, die als Korrekturmittel dient, und
**daß** außerhalb eines externen Resonators (3) ein weiteres System (4) von angepaßten Phasenplatten als externe generalisierte Linsen den emittierten Strahl in die gewünschte Amplituden-/Phasenverteilung und Leistungsdichte (5) transformiert.

2. Verfahren nach Patentanspruch 1, **dadurch gekennzeichnet,**
**daß** bei der Einkopplung von Pumpstrahlung in einen Glasfaserverstärker ein O-förmiges Strahlprofil generiert wird.

3. Verfahren nach Patentanspruch 2, **dadurch gekennzeichnet,**
**daß** das O-förmige Strahlprofil direkt vom externen Resonator (3) emittiert wird.

4. Verfahren nach einem der Patentansprüche 1 bis 3, **dadurch gekennzeichnet,**
**daß** die internen Korrekturelemente durch ein globales Optimierungsverfahren und die internen Korrekturelemente mit den externen generalisierten Linsen zusammen durch ein globales Optimierungsverfahren gestaltet werden.

5. Vorrichtung zur Durchführung des Verfahrens nach einem der Patentansprüche 1 bis 4, **dadurch gekennzeichnet,**
**daß** zwischen zwei oder mehreren Spiegeln (1) Einzelemitter in Form von Einzeldioden einer Diodenmatrix oder Diodenbarren (2) angeordnet sind,
**daß** mindestens einer der Spiegel (1) eine besondere, nichtsphärische Fläche aufweist und als internes Korrekturmittel dient und
**daß** außerhalb des externen Resonators (3) ein sekundärer Strahlformer (4) angeordnet ist, der das weitere System (4) von Phasenplatten als externe generalisierte Linsen umfaßt, das den emittierten Strahl in die gewünschte Amplituden-/Phasenverteilung und Leistungsdichte (5) transformiert.

6. Vorrichtung nach Patentanspruch 5, **dadurch gekennzeichnet,**
**daß** die Spiegel (1) sphärisch geformt sind und
**daß** im Resonatorstrahlengang mindestens eine nichtsphärische Phasenplatte als internes Korrekturelement angeordnet ist.

7. Vorrichtung nach Patentanspruch 5 oder 6, **dadurch gekennzeichnet,**
**daß** bei der Anordnung von Streifendioden als Laserdioden die internen und die externen Korrekturelemente nur eine eindimensionale Struktur aufweisen.

8. Vorrichtung nach einem der Patentansprüche 5 bis 6, **dadurch gekennzeichnet,**
**daß** vertikal emittierende Dioden (VCSEL) in Form von Einzeldioden oder VCSEL-Matrizen angeordnet sind, deren Emission transversal mehrmodig wird, sobald die emittierende Apertur einige µm überschreitet und
**daß** die Korrekturelemente eine zweidimensionale Struktur aufweisen.

9. Vorrichtung nach einem der Patentansprüche 5 bis 8, **dadurch gekennzeichnet,**
**daß** das resonatorinterne Korrekturelement der Laserdiodenkristall ist, dessen Oberflächen mit einem phasenschiebenden Relief versehen sind.

## Claims

1. Method for the coherent addition of the emissions from solid-state lasers, individual emitters in the form of individual diodes of a diode matrix or diode bars (2) being placed between two or more mirrors (1), **characterized in that**
at least one of said mirrors (1) has a non-spherical surface which serves as a correction means, and
outside of an external resonator (3) a further system (4) of adapted phase plates as external generalized lenses transforms the emitted beam into the desired amplitude/phase distribution and power density (5).

2. Method according to claim 1, **characterized in that**
an O-shaped beam profile is generated when pumping radiation is coupled into a glass-fibre amplifier.

3. Method according to claim 2, **characterized in that**
the O-shaped beam profile is emitted directly by the external resonator (3).

4. Method according to any one of claims 1 to 3, **characterized in that**
the internal correction elements are formed by a global optimization method and the internal correction elements together with the external generalized lenses are formed by a global optimization method.

5. Device for implementing the method according to any one of claims 1 to 4, **characterized in that**
individual emitters in the form of individual diodes of a diode matrix or diode bars (2) are disposed between two or more mirrors (1),
at least one of the mirrors (1) has a special, non-spherical surface and serves as an internal correction means, and
a secondary beam shaper (4) is disposed outside of the external resonator (3), said beam shaper (4) comprising the further system (4) of phase plates as external generalized lenses, said further system (4) transforming the emitted beam into the desired amplitude/phase distribution and power density (5).

6. Device according to claim 5, **characterized in that**
the mirrors (1) are spherically formed and
at least one non-spherical phase plate is disposed as an internal correction element in the optical path of the resonator.

7. Device according to claim 5 or 6, **characterized in that**
if strip diodes are disposed as laser diodes, the internal and external correction elements have only a one-dimensional structure.

8. Device according to any one of claims 5 to 6, **characterized in that**
vertically emitting diodes (VCSELs) are disposed in the form of individual diodes or VCSEL matrixes, the emissions from which become transversal multimode as soon as the emitting aperture exceeds a few µm and
the correction elements have a two-dimensional structure.

9. Device according to any one of claims 5 to 8, **characterized in that**
the resonator-internal correction element is the laser diode crystal, whose surfaces are provided with a phase-shifting relief.

## Revendications

1. Procédé d'addition cohérente d'émission de lasers à semiconducteurs par laquelle des émetteurs individuels de lumière sont intercalés, sous forme de diodes individuelles sur une matrice à diodes ou sur une barrette de diodes (2), entre deux ou plusieurs miroirs (1), **caractérisé en ce que**
au moins un desdits miroirs (1) présente une surface non sphérique servant de moyen correcteur et que
à l'extérieur d'un résonateur externe (3), un système supplémentaire (4), constitué de lames de phases adaptées en tant que lentilles externes généralisées, transforme le faisceau émis en fonction de la distribution d'amplitudes/de phases et de la puissance de rendement désirées.

2. Procédé selon la revendication 1, **caractérisé en ce que**
en injectant un faisceau par pompage dans un amplificateur de fibres optiques l'on génère un profil annulaire du faisceau.

3. Procédé selon la revendication 2, **caractérisé en ce que**
le profil annulaire du faisceau est émis directement par le résonateur externe (3).

4. Procédé selon l'une quelconque des revendications 1 à 3, **caractérisé en ce que**
un procédé d'optimisation global permet de construire les éléments internes de correction ainsi que les éléments internes de correction conjointement avec les lentilles externes généralisées.

5. Dispositif de réalisation du procédé selon l'une quelconque des revendications 1 à 4, **caractérisé en ce que**
des émetteurs individuels de lumière sont placés entre deux ou plusieurs miroirs sous forme de diodes individuelles d'une matrice à diodes ou d'une barrette de diodes (2),
au moins un desdits miroirs (1) présente une surface particulière non sphérique et sert de moyen correcteur, et
qu'une source secondaire de laser (4) est placée à l'extérieur du résonateur externe (3) comprenant le système supplémentaire (4) de lames de phases adaptées en tant que lentilles externes généralisées destiné à transformer le faisceau émis en distribution d'amplitudes/phases et puissance de rendement désirée.

6. Dispositif selon la revendication 5, **caractérisé en ce que** les miroirs (1) ont une forme sphérique et
qu'au moins une lame de phase non sphérique se trouve dans la trajectoire du faisceau en guise d'élément de correction.

7. Dispositif selon la revendication 5 ou 6, **caractérisé en ce que**
les éléments internes et externes de correction ne présentent qu'une structure unidimensionnelle lorsque les diodes laser sont agencées sous forme de bande de diodes.

8. Dispositif selon l'une quelconque des revendications 5 à 6, **caractérisé en ce que**
les diodes à émission verticale (diodes VCSEL) sont agencées sous forme de diodes individuelles ou de matrices de diodes VCSEL dont l'émission est multimode transverse dès que l'ouverture émettrice dépasse quelques •m et que
les éléments de correction présentent une structure bidimensionnelle.

9. Dispositif selon l'une quelconque des revendications 5 à 8, **caractérisé en ce que**
l'élément de correction interne au résonateur est constitué par le cristal de la diode laser dont la surface est pourvue d'un relief à effet déphaseur.
